# FASCICULE DE BREVET EUROPEEN

(11) **EP 4 120 271 B1**
(45) Date de publication et mention de la délivrance du brevet: **30.04.2025**
(21) Numéro de dépôt: 22183550.7
(22) Date de dépôt: 07.07.2022
(51) Int. Cl.: G11C 11/56, G11C 13/00

(54) **PROCEDE DE LECTURE D'UNE RRAM MULTI-NIVEAUX**
LESEVERFAHREN EINES MEHRSTUFIGEN RRAM-SPEICHERS
METHOD FOR READING A MULTI-LEVEL RRAM

(30) Priorité: 12.07.2021 FR 2107535
(43) Date de publication de la demande: 18.01.2023
(73) Titulaire: Commissariat à l'Energie Atomique et aux Energies Alternatives, 75015 Paris (FR)
(72) Inventeur: MOLAS, Gabriel, 38054 GRENOBLE CEDEX 09 (FR); MINGUET LOPEZ, Joël, 38054 GRENOBLE CEDEX 09 (FR); RUMMENS, François, 38054 GRENOBLE CEDEX 09 (FR); VIANELLO, Elisa, 38054 GRENOBLE CEDEX 09 (FR)
(74) Mandataire: Brevalex

(56) Documents cités:
- US-A1- 2015 243 352
- US-A1- 2016 035 416
- US-B1- 10 283 197

## Description

### DOMAINE TECHNIQUE

La présente demande se rapporte au domaine des mémoires non volatiles et plus précisément celui des mémoires résistives dotées de cellules dites « multi-niveaux » susceptibles d'adopter un nombre d'états de programmation supérieur à deux pour permettre de coder plus de deux niveaux distincts par cellule et en particulier plus d'un bit par cellule.

Elle concerne plus précisément un procédé de commande et un circuit de commande pour la lecture et la programmation de telles cellules mémoire résistives.

### ART ANTERIEUR

Parmi les mémoires non volatiles, les mémoires résistives ont pour avantages de présenter une vitesse de fonctionnement élevée, une faible consommation d'énergie électrique et une longue durée de vie.

Les mémoires résistives sont formées d'un ensemble de cellules dotées chacune d'au moins un élément résistif de résistivité variable. Chaque élément résistif comporte un matériau capable de basculer de manière réversible entre au moins un état dit « fortement résistif » et au moins un autre état dit « faiblement résistif », appelés respectivement « HRS » (pour « High-Resistance State » en anglais) et « LRS » (« Low-Resistance State »). Le mécanisme à l'origine de la variation de résistance de la cellule mémoire dépend de la technologie utilisée. Plusieurs technologies de mémoires résistives existent parmi lesquelles on peut citer notamment les mémoires à changement de phase PCRAM (pour « Phase-Change Random-Access Memory »), les mémoires à pont conducteur CBRAM (pour « Conductive-Bridging Random- Access Memory ») et les mémoires à base d'oxyde OxRAM (pour « Oxyde-based Random Access Memory »).

Une cellule mémoire résistive dotée d'un élément résistif et programmable pour avoir un état parmi deux états de résistance distincts LRS ou HRS possibles et n'est capable de stocker qu'un seul bit de données.

Récemment, des cellules mémoires résistives pourvues chacune d'un élément résistif programmable entre plus de deux niveaux distincts sont apparues. De telles cellules peuvent permettre ainsi chacune de stocker plusieurs bits de données.

Le document "High-Density 3D Monolithically Integrated Multiple 1T-1R Multi-Level-Cell for Neural Networks", de Esmanhotto et al. 2020 IEEE International Electron Devices Meeting (IEDM) présente par exemple un tel type de cellule mémoire, intégrée à une matrice, et permettant l'utilisation de neuf niveaux de conductance distincts, afin d'implémenter un codage dit « multi-niveaux » ou MLC (pour « Multi Level Coding »). La cellule mémoire est ici de type 1T-1R c'est à dire formée d'un élément résistif associé à un transistor d'accès permettant alternativement de bloquer l'accès ou de permettre l'accès à l'élément de mémorisation résistif pour des opérations de lecture ou d'écriture ou d'effacement ou de programmation tout en limitant des courants de fuite indésirables dans le reste de la matrice.

Le document US2015/243352 A1 présente une méthode de lecture de données multi-niveaux stockées dans une cellule de mémoire résistive d'un dispositif de mémoire non volatile.

Avec un tel type de structure, une lecture à faible tension, par exemple de l'ordre de 100 mV, est possible et permet de distinguer différents niveaux de courant traversant l'élément résistif et correspondant à différents états possibles stockés dans la cellule mémoire.

Toutefois, les cellules mémoires de type 1T-1R, de par leur transistor d'accès posent problème en matière d'encombrement.

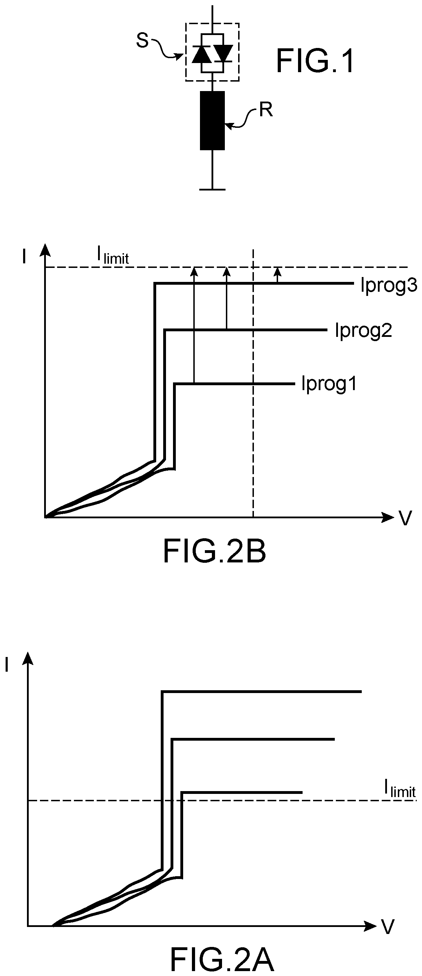

Des cellules de type 1S-1R pour lesquelles le transistor est remplacé par un sélecteur formé d'un commutateur à deux terminaux ont quant à elles un encombrement réduit. La figure 1 donne un schéma électrique équivalent d'une telle cellule 1S-1R. Le sélecteur S fonctionne typiquement comme au moins une diode voire comme deux diodes montées en antiparallèle ou tête-bêche. Le sélecteur S est formé d'un empilement de couches généralement réalisé dans une partie dite de BEOL (pour « Back End Of Line ») d'un dispositif microélectronique. Cette partie dans laquelle les éléments résistifs sont également formés est typiquement également dédiée aux interconnexions.

Les figures 2A-2B, par le biais de caractéristiques tension-courant, servent à illustrer différents paramètres d'une opération de lecture d'une cellule 1S-1R susceptible d'être programmée sur un parmi trois états de programmation distincts possibles.

Lors d'une lecture de la cellule 15-1R si le courant de lecture est supérieur aux courants de programmation Iprog1, Iprog2, Iprog3 (figure 2A), la mémoire risque d'être programmée à ce courant de lecture. On dit alors qu'elle est sur-programmée.

Dans un autre cas, où le courant de lecture est inférieur aux courants de programmation (figure 2B), il est alors difficile d'établir une distinction du niveau mémorisé parmi les différents niveaux auxquels la mémoire est susceptible d'être programmée. On lit un même courant dans tous les cas, quel que soit l'état de résistivité auquel se trouve l'élément résistif programmé.

Il se pose le problème de réaliser la lecture d'un état de programmation d'une cellule mémoire RRAM programmée selon un codage multi-niveaux.

### EXPOSÉ DE L'INVENTION

Ainsi, selon un aspect, la présente invention concerne un dispositif mémoire formé de cellules mémoires résistives dotées chacune d'un élément de mémoire résistive associé en série à un sélecteur, chaque cellule implémentant un codage dit « multi-niveaux » et étant programmée à un état de programmation donné parmi k avec k > 2 états de programmation possibles,
le dispositif comprenant un circuit de lecture configuré pour, lors d'une opération de lecture sur une cellule donnée : appliquer une séquence d'au moins deux tensions de lecture successives et différentes à la cellule donnée.

Les tensions de lecture appliquées sont sélectionnées en fonction des états de programmation que la cellule mémoire peut prendre.

Le circuit de lecture est configuré de sorte que ladite séquence comprend l'application d'une première tension de lecture à la cellule donnée, la première tension de lecture appartenant à une première gamme de tensions entre une première tension de seuil et une deuxième tension de seuil, et étant sélectionnée parmi un ensemble de tensions de lecture d'une séquence de tensions de lecture différentes auxquelles une cellule de ladite mémoire est susceptible d'être soumise lors de ladite opération de lecture, puis l'application d'une deuxième tension de lecture, de ladite séquence de tensions de lecture, la deuxième tension de lecture étant différente de la première tension de lecture et appartenant à une deuxième gamme de tensions entre la deuxième tension de seuil et une troisième tension de seuil, l'état de programmation donné étant déterminé en fonction de valeurs respectives d'un premier courant de lecture traversant ladite cellule donnée résultant de l'application de ladite première tension de lecture et d'un deuxième courant de lecture traversant ladite cellule donnée consécutivement à l'application de ladite deuxième tension de lecture, ledit état de programmation donné étant déterminé en fonction de la valeur d'une somme entre ledit premier courant de lecture et ledit deuxième courant de lecture.

Le circuit de lecture est configuré pour détecter à chaque tension de lecture appliquée de ladite séquence si un courant de lecture traversant ladite cellule donnée et résultant de l'application de ladite de tension de lecture correspond à un premier niveau de courant de fuite du sélecteur lorsque ce sélecteur se trouve dans un état bloqué ou si le courant de lecture correspond à un deuxième niveau de courant lorsque le sélecteur se trouve dans un état passant.

La tension de lecture à laquelle le sélecteur devient passant est liée à l'état de programmation de la mémoire.

Avantageusement, lors de l'opération de lecture la séquence de tensions de lecture différentes est appliquée à ladite cellule mémoire donnée selon un ordre croissant de tensions de lecture ou selon un ordre décroissant de tensions de lecture.

Avantageusement, le sélecteur peut être un commutateur à deux terminaux, en particulier de type interrupteur à seuil ovonique (OTS).

Avantageusement, l'élément de mémoire résistive est un élément de mémoire résistive à base d'oxyde (OxRAM).

Selon un mode de réalisation particulier, le circuit de lecture peut être doté d'un amplificateur ayant une entrée non-inverseuse à laquelle la tension de lecture est appliquée et une entrée inverseuse connectée au drain d'un transistor monté en drain commun et couplé en sortie du sélecteur.

Selon une mise en œuvre particulière du dispositif, le circuit de lecture peut être configuré pour comparer un courant image issu d'un premier miroir de courant recevant un courant issu du sélecteur à un autre courant issu d'un deuxième miroir de courant auquel un courant de référence est appliqué.

Selon un mode de réalisation particulier, le circuit de lecture peut être doté d'un comparateur pour comparer une tension en sortie de l'amplificateur avec une tension de référence.

Selon un mode de réalisation particulier, le circuit de lecture peut être doté d'une capacité d'intégration chargée par un courant image d'un courant issu du sélecteur, le circuit de lecture étant configuré pour lors de l'opération de lecture selon ladite séquence de tensions décharger la capacité d'intégration consécutivement à l'application d'une première tension de lecture de ladite séquence et préalablement à l'application d'une deuxième tension de lecture suivant ladite première tension de lecture dans ladite séquence de tensions.

Selon un aspect, la présente invention prévoit un procédé de commande d'une mémoire résistive formée de cellules mémoires résistives dotées chacune d'un élément de mémoire résistive associé en série à un sélecteur, chaque cellule implémentant un codage dit « multi-niveaux » et étant programmée dans un état de programmation donné parmi k (avec k > 2) états résistifs possibles, le procédé comprenant, lors d'une opération de lecture d'un état de programmation donné enregistré dans une cellule donnée (3i) parmi lesdites cellules mémoires résistives, des étapes consistant à :
- appliquer une première tension de lecture à la cellule donnée, la première tension de lecture appartenant à une première gamme de tensions entre une première tension de seuil et une deuxième tension de seuil, et étant sélectionnée parmi un ensemble de tensions de lecture d'une séquence de tensions de lecture différentes auxquelles une cellule de ladite mémoire est susceptible d'être soumise lors de ladite opération de lecture, puis
- appliquer une deuxième tension de lecture, de ladite séquence de tensions de lecture, la deuxième tension de lecture étant différente de la première tension de lecture et appartenant à une deuxième gamme de tensions entre la deuxième tension de seuil et une troisième tension de seuil, l'état de programmation donné étant déterminé en fonction de valeurs respectives d'un premier courant de lecture traversant ladite cellule donnée consécutivement à l'application de ladite première tension de lecture et d'un deuxième courant de lecture traversant ladite cellule donnée consécutivement à l'application de ladite deuxième tension de lecture, ledit état de programmation donné étant déterminé en fonction de la valeur d'une somme entre ledit premier courant de lecture et ledit deuxième courant de lecture, ou,
- déclencher la fin à l'opération de lecture :
   lorsque la première tension de lecture est la tension la plus élevée de ladite séquence de tensions et que le premier courant traversant ladite cellule donné et consécutif à l'application de ladite première tension de lecture correspond à un niveau de courant de fuite du sélecteur lorsque ce sélecteur se trouve dans un état bloqué, ou bien
   lorsque la première tension de lecture est la tension la plus faible de ladite séquence de tensions et que le premier courant correspond à un niveau de courant lorsque le sélecteur se trouve dans un état passant.

Selon une possibilité de mise en œuvre, après application de la première tension de lecture et préalablement à l'application de la deuxième tension de lecture ou au déclenchement de la fin de l'opération de lecture, le procédé peut comprendre :
- une étape de détection binaire consistant à déterminer si le premier courant de lecture correspond à un niveau de courant de fuite du sélecteur lorsque ce sélecteur se trouve dans un état bloqué ou bien si le premier courant correspond à un niveau de courant lorsque le sélecteur se trouve dans un état passant, en particulier par comparaison du premier courant de lecture ou d'une image du premier courant de lecture sous forme d'une tension ou d'un courant à un seuil donné.

Selon une possibilité de mise en œuvre, l'opération de lecture peut comprendre en outre, après l'étape consistant à appliquer la deuxième tension de lecture :
- appliquer une troisième tension de lecture, de ladite séquence de tensions de lecture, la troisième tension de lecture étant différente desdites première tension de lecture et deuxième tension de lecture et appartenant à une troisième gamme de tensions entre la troisième tension de seuil et une quatrième tension de seuil, ou
- déclencher la fin à l'opération de lecture :
   lorsque la deuxième tension de lecture est, hormis la première tension de lecture la tension la plus élevée de ladite séquence de tensions et que le deuxième courant de lecture correspond à un niveau de courant de fuite du sélecteur lorsque ce sélecteur se trouve dans un état bloqué, ou bien
   lorsque la deuxième tension de lecture est, hormis la première tension de lecture, la tension la plus faible de ladite séquence de tensions et que le deuxième courant de lecture correspond à un niveau de courant du sélecteur lorsque le sélecteur se trouve dans un état passant.

L'opération de lecture peut comprendre en outre, après application de la troisième tension de lecture :
- une étape de détermination dudit état de programmation donné en fonction de la valeur d'une somme entre ledit premier courant de lecture, ledit deuxième courant de lecture, et un troisième courant traversant ladite cellule donné consécutivement à l'application de ladite troisième tension de lecture.

Avantageusement le procédé peut comprendre en outre, après application de la deuxième tension de lecture et préalablement à l'application de la troisième tension de lecture ou au déclenchement de la fin de l'opération de lecture, une étape de détection binaire consistant à déterminer si le deuxième courant de lecture correspond à un niveau de courant de fuite du sélecteur lorsque ce sélecteur se trouve dans un état bloqué ou bien si le deuxième courant correspond à un niveau de courant lorsque le sélecteur se trouve dans un état passant.

Selon un mode avantageux, préalablement à l'opération de lecture le procédé comprend une étape consistant à effectuer une programmation de l'état donné est effectué en appliquant une succession d'impulsions de courant à la cellule donnée.

### BRÈVE DESCRIPTION DES DESSINS

La présente invention sera mieux comprise sur la base de la description qui va suivre et des dessins en annexe sur lesquels :
La figure 1 donne un schéma électrique équivalent d'une cellule mémoire résistive RRAM conventionnelle de type 15-1R°;
Les figures 2A, 2B servent à illustrer les contraintes liées à la lecture de différents niveaux de courant de lecture dans une cellule mémoire « multi-niveaux » permettant de réaliser un codage sur plus de deux niveaux°;
La figure 3 sert à illustrer une mémoire RRAM 3D dotée de cellules mémoires multi-niveaux°;
La figure 4 sert à illustrer une mémoire RRAM dotée de cellules mémoires multi-niveaux et ayant un agencement de type « cross-bar »°;
La figure 5 sert à illustrer des caractéristiques courant de lecture-tension de lecture lors d'opérations de lecture menées sur une cellule mémoire RRAM multi-niveaux et susceptible d'être à un état de programmation donné parmi trois états résistifs distincts possibles°;
La figure 6 sert à illustrer une opération de lecture d'une cellule mémoire multi-niveaux durant laquelle on applique une séquence de tensions de lecture croissantes afin de déterminer l'état de programmation auquel cette cellule est programmée ;
La figure 7 sert à illustrer une opération de lecture d'une cellule mémoire multi-niveaux durant laquelle on applique une séquence de tensions de lecture décroissantes afin de déterminer l'état de programmation auquel cette cellule est programmée ;
La figure 8 sert à illustrer une opération de lecture menée sur une cellule mémoire RRAM multi-niveaux et susceptible d'être à un état de programmation parmi quatre états de programmation distincts possibles°;
La figure 9 sert à illustrer un premier exemple de circuit de lecture de cellule RRAM de type 15-1R ;
La figure 10 sert à illustrer un deuxième exemple de circuit de lecture de cellule RRAM de type 1S-1R ;
La figure 11 sert à illustrer un troisième exemple de circuit de lecture de cellule RRAM de type 15-1R ;
La figure 12 sert à illustrer un quatrième exemple de circuit de lecture de cellule RRAM de type 15-1R ;
Les figures 13A, 13B servent à illustrer une première méthode de programmation de cellule RRAM multi-niveaux et de type 15-1R ;
Les figures 14A, 14B servent à illustrer une deuxième méthode de programmation de cellule RRAM multi-niveaux et de type 15-1R ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

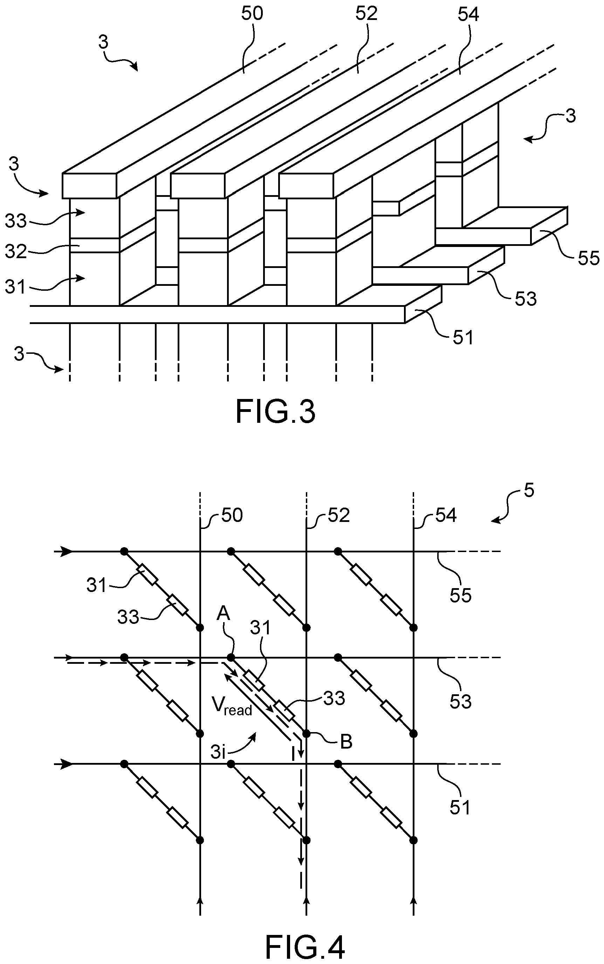

Sur la figure 3, une vue en perspective d'une mémoire 1 résistive est donnée.

La mémoire 1 a ici pour particularité d'être formée d'une pluralité de cellules mémoires 3 multi-niveaux (MLC pour « Multi Level Cells ») chacune permettant de stocker plus d'un bit par cellule. Ainsi, au lieu de deux uniques états résistifs de résistivité « élevée » et « faible » (respectivement HRS et LRS) chacun correspondant à un état de programmation, les cellules 3 peuvent être ici mises à un état « de programmation » donné parmi plus de deux états de programmation distincts. On définit alors au moins un état résistif intermédiaire entre l'état résistif LRS et l'état résistif HRS.

Chaque cellule 3 de la mémoire 1 est ici intercalée entre : un premier élément conducteur 50, 52, 54; et un deuxième élément conducteur 51, 53, 55. Les éléments conducteurs 50, 51, 52, 53, 54 et 55 sont, dans l'exemple illustré, disposés de telle sorte qu'ils forment une matrice dont chaque croisement correspond à un emplacement d'une cellule mémoire. La mémoire 1 présente dans cet exemple de réalisation particulier une structure tridimensionnelle. Un procédé de lecture selon l'invention peut toutefois s'appliquer à d'autres types d'agencements de mémoire 1.

Chaque cellule mémoire 3 comporte un empilement, définissant une connexion électrique en série : d'un élément 31 de mémorisation résistif et d'un sélecteur 33. Les éléments conducteurs 50, 51, 52, 53, 54 et 55 permettent d'adresser les cellules mémoires 3 de la mémoire 1, chaque cellule mémoire 3 étant connectée à une paire d'éléments conducteurs qui lui est propre.

Pour lire ou écrire (autrement dit programmer) l'élément 31 de mémorisation résistif, on vient sélectionner la cellule mémoire 3 considérée. La sélection s'effectue, par exemple, en appliquant une différence de potentiels entre la paire d'éléments conducteurs propre à la cellule mémoire 3 considérée. Cette différence de potentiels est susceptible de modifier l'état du sélecteur 33, de sorte qu'un courant électrique puisse circuler dans la cellule mémoire 3 considérée. Une fois l'opération de lecture ou d'écriture terminée, on cesse d'appliquer une différence de potentiels entre les deux éléments conducteurs formant la paire d'éléments conducteurs de la cellule mémoire 3 considérée.

La mémoire considérée peut être une mémoire à accès aléatoire par liaison conductrice (pour « Conductive Bridging Random Access Memory » - CBRAM), ou selon une variante préférée, une mémoire de type mémoire résistive à base d'oxyde (« oxide-based resistive memory » ou OxRAM). L'élément 31 de mémorisation résistif peut être dans ce cas formé d'un empilement d'une couche d'oxyde, par exemple une couche de dioxyde d'Hafnium (HfO₂) et d'une couche métallique, par exemple une couche de titane (Ti). Un exemple de réalisation particulier prévoit un empilement d'une couche de HfO₂ d'épaisseur comprise entre 5 nm et 10 nm, par exemple de l'ordre de 10 nm et d'une couche de Ti d'épaisseur comprise entre 5 nm et 10 nm par exemple de 10 nm. L'élément 31 de mémorisation résistif peut être en outre intercalé entre une paire d'électrodes, par exemple à base de TiN.

Le sélecteur 33 est un commutateur à deux terminaux formant au moins une diode ou deux diodes tête-bêche. Ce sélecteur 33 peut être en particulier un commutateur ovonique à seuil (« Ovonic Threshold Switch » ou OTS), par exemple réalisé à base de matériau(x) chalcogénure(s). Un exemple de réalisation particulier prévoit un commutateur OTS formé d'une couche à base de GeSeSbN (encore appelé « GSSN ») d'épaisseur comprise entre 5nm et 25nm, par exemple de l'ordre de 10 nm.

La figure 4 représente, de façon schématique, un mode de réalisation d'une matrice bidimensionnelle 5 de cellules mémoires de type 15-1R formées chacune d'un élément de mémorisation 31 et d'un sélecteur 33, et selon un agencement de type « cross-bar » (autrement dit matriciel à croisements).

En supposant que l'on veuille lire un état de programmation d'une cellule mémoire donnée 3i de la matrice 5, une tension, notée Vread, est appliquée ici entre les éléments conducteurs 52 et 53 connectés de part et d'autre du point mémoire 3. Concomitamment, tous les autres éléments conducteurs 50, 51, 54 et 55 sont maintenus typiquement à un potentiel de l'ordre de zéro volt. On impose ainsi entre les points A et B, où la cellule mémoire 3i contacte respectivement les éléments conducteurs 53 et 52, une différence de potentiel approximativement égale, aux chutes de tension près dans les conducteurs, à la tension de lecture Vread.

Dans la mesure où les cellules sont ici des cellules multi-niveaux MLC, programmés sur plus de deux états distincts, une opération de lecture particulière est mise en œuvre.

La lecture est ici susceptible d'être réalisée en plusieurs sous-étapes de lectures successives, chacune pouvant comprendre l'application d'une tension de lecture et la détection d'un courant de lecture, avec des niveaux de tensions de lecture différents d'une sous-étape à l'autre.

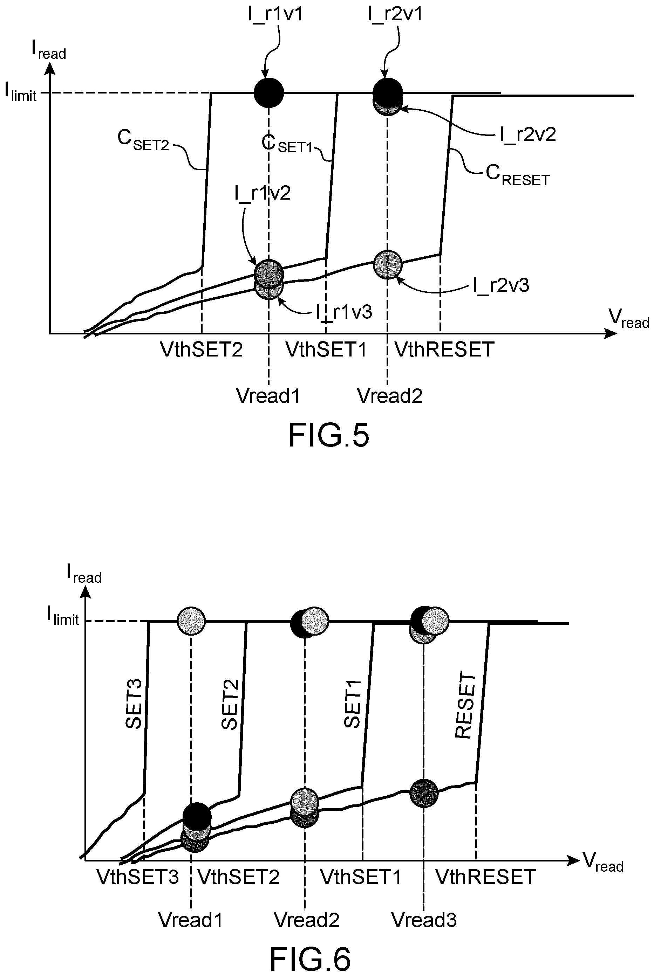

Un exemple d'opération de lecture d'une cellule mémoire résistive d'une mémoire dont les cellules ont chacune été préalablement programmées à un état de programmation donné, parmi trois états de programmation distincts possibles, va à présent être décrit en liaison avec la figure 5.

Ces états de programmation sont susceptibles d'être obtenus par le biais de deux niveaux de courants de programmation distincts, ISET1, et ISET2. Par exemple, on peut prévoir ISET1 de l'ordre de 100 µA, et ISET2 de l'ordre de 200 µA.

Le contrôle du courant de programmation ISET, peut être réalisé par le biais de transistors situés en extrémité d'une ligne et/ou d'une colonne d'un agencement matriciel. Typiquement, on peut prévoir un transistor par ligne et un transistor dédié à la programmation par colonne dans l'agencement matriciel. En ajustant la tension de grille de ce transistor dédié, on peut alors contrôler le courant qui va traverser et ainsi programmer une cellule mémoire pendant une opération d'écriture. Quelle que soit la valeur de courant de programmation ISET, on applique typiquement une tension de programmation aux bornes de la cellule généralement supérieure à la tension de seuil VthRESET, c'est-à-dire la tension de seuil de la cellule 1S1R qui se trouve à l'état effacé. Pour effectuer une opération de lecture sur une cellule mémoire, on lui applique tout d'abord une première tension de lecture notée Vread1.

Cette première tension de lecture Vread1 est égale à une valeur comprise dans une première plage de tensions, définie ici entre une première tension de seuil, notée VthSET2 des cellules et une deuxième tension de seuil de cellules notée VthSET1 des cellules avec Vread distinct de VthSET1 et VthSET2. On vient alors mesurer la valeur d'un courant de lecture Iread1 circulant dans la cellule mémoire.

La mémoire est programmée à un courant ISET donné. De cet état de programmation fixé par le courant de programmation dépend la tension de seuil de la structure 1S1R au de-là de laquelle elle commute et devient conductrice. Plus cette structure est programmée à courant fort, plus la tension de seuil est faible. Ainsi, si on programme à ISET1=100µA, on aura une tension de seuil Vth1 de seuil à laquelle la cellule 1SR commute, tandis que si l'on programme à ISET2=200µA, on aura une tension de seuil Vth2, telle que Vth2<Vth1.

Si, dans un premier cas, l'élément résistif de la cellule est programmé à un premier état de programmation, son sélecteur est rendu passant et la première valeur de courant mesurée (point l_r1v1 sur la courbe CSET2) correspond à un courant Ilimit. Le courant Ilimit est un courant traversant la cellule lorsque son sélecteur est passant et qui peut être par exemple de l'ordre de plusieurs dizaines ou centaines de micro-ampères, par exemple de l'ordre de 100 µA.

Le courant Ilimit est un courant limitant la conduction de la cellule 1S1R pendant la lecture. Quel que soit le niveau auquel la mémoire est programmé (courant Iprog élevé ou faible), on lit ici un même courant Ilimit lorsque la cellule commute. Ce courant Ilimit peut être contrôlé par le transistor dédié en bout de ligne ou de colonne en contrôlant la tension appliquée sur la grille de ce transistor.

Dans un deuxième cas, où l'élément résistif 31 est programmé à un deuxième état de programmation, ici obtenu par le biais d'un courant de programmation intermédiaire et de niveau inférieur à celui du courant de programmation correspondant au premier état de programmation, le sélecteur 33 est maintenu bloqué et la première valeur de courant mesurée (points I_r1v2 sur la courbe CSET1) correspond cette fois à un courant de fuite loff_OTS du sélecteur 33. La détection d'un niveau de courant loff_OTS ou Ilimit peut se faire par détection d'un dépassement d'au moins un seuil comme cela sera décrit ultérieurement.

Dans un troisième cas où l'élément résistif 31 est dans un troisième état de programmation, correspondant à un niveau de courant de programmation inférieur à celui du premier et du deuxième état de programmation, le sélecteur 33 est maintenu bloqué et la première valeur de courant mesurée (point l_r1v3 sur la courbe CRESET) correspond au courant loff_OTS de fuite du sélecteur 33.

Ensuite, selon une deuxième sous-étape de l'opération de lecture, on applique à la même cellule que l'on souhaite lire une deuxième tension de lecture notée Vread2 et dans cet exemple supérieure à la première tension de lecture Vread1.

Cette deuxième tension de lecture Vread2 est prévue dans une deuxième plage de tensions, différente de la première plage de tensions et cette fois comprise entre la deuxième tension de seuil VthSET1 et une troisième tension de seuil, notée VthRESET.

On vient alors mesurer la valeur d'un courant circulant dans la cellule mémoire. On mesure, en appliquant la tension Vread2, une deuxième valeur de courant de lecture Iread2.

Dans un cas où l'élément résistif 31 est dans le premier état de programmation, le sélecteur 33 est rendu passant et la deuxième valeur de courant mesurée correspond (point l_r2v1 sur la courbe CSET1) au courant Ilimit.

Dans un autre cas où l'élément résistif 31 est dans le deuxième état programmation, le sélecteur 33 est passant et la deuxième valeur de courant mesurée (point l_r2v2 sur la courbe CSET2) correspond au courant Ilimit.

Dans un troisième cas où l'élément résistif 31 est dans le troisième état programmation, le sélecteur est maintenu bloqué et la deuxième valeur de courant mesurée (point l_r2v3 sur la courbe CRESET) correspond à un courant de fuite loffOTS du sélecteur 33.

On peut additionner ensuite les valeurs de courant lues à chacune des sous-étapes lors desquelles on applique des tensions de lecture distinctes.

Dans le cas décrit précédemment où l'on effectue deux lectures successives avec deux tensions de lectures distinctes, on fait la somme entre la première valeur de courant Iread1 lue consécutivement à l'application de la première tension de lecture vread1 et la deuxième valeur de courant Iread2 lue consécutivement à l'application de la deuxième tension de lecture vread2.

Le tableau ci-dessous répertorie des résultats d'une opération de lecture comprenant deux sous-étapes successives de lecture « Read1 » et « Read2 » d'une cellule donnée consécutivement à l'application respectivement d'une première tension de lecture Vread1 puis d'une deuxième tension de lecture Vread2, dans un cas théorique où l'on considère Ilimit = 100µA et où le courant de fuite IffOTS est de 0 µA.

La somme Iread1+lread2 de la premier valeur du courant résultant de l'application de la première tension et de la deuxième valeur du courant résultant de l'application de la deuxième tension, permet ici de distinguer de manière précise 3 niveaux distincts de courant correspondant chacun à l'un des 3 états de programmation à laquelle la cellule est susceptible d'être programmée.

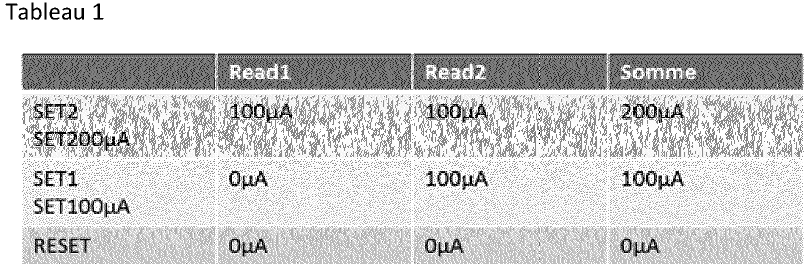

Ainsi, lorsque Iread1+Iread2 = 2*IffOTS, cela signifie que la cellule mémoire lue se trouve dans le troisième état de programmation, obtenu par le courant de programmation ISET2 le plus élevé.

Lorsque Iread1+lread2 = Ilimit + loffOTS, cela signifie que la cellule mémoire lue se trouve dans le deuxième état de programmation, obtenu par un courant de programmation ISET1 intermédiaire.

Lorsque Iread1+Iread2= 2*llimit, cela signifie que la cellule mémoire lue se trouve dans le premier état programmation

A chacune des sous-étapes de lecture de courant Iread1 puis Iread2, on lit ici soit un courant Ilimit soit un courant loffOTS dont les valeurs respectives peuvent être aisément distinguées l'une de l'autre et qui sont peu dépendantes des variabilités de la mémoire lue.

En particulier, dans le cas où le sélecteur 33 est de type OTS, le courant Ilimit est choisi de préférence de sorte que Ilimit > Ihold-OTS avec Ihold-OTS le courant de maintien de l'OTS en dessous duquel celui-ci reste à l'état bloqué.

Le courant Ilimit est établi de préférence inférieur aux courants de programmation le plus faible parmi les courants de programmations ISET1, ISET2 utilisés, par exemple si l'on effectue une programmation à différents niveaux de courants 100 µA, ..., k*100 µA (avec k un entier tel que k>1), on prévoit Ilimit tel que Ilimit < 100 µA.

Le courant de fuite loffOTS du sélecteur 33 peut être ajusté. Dans le cas par exemple où le sélecteur 33 est de type OTS à base d'un matériau GSSN, l'épaisseur de ce matériau GSSN peut être adaptée en fonction du courant de fuite souhaité. En diminuant l'épaisseur de matériau GSSN on augmente la valeur du courant de fuite loffOTS

Les différentes tensions de seuil VthSET1, VthSET2, VthRESET dépendent notamment des compositions respectives de l'élément résistif 31 et du sélecteur 33, par exemple du type d'OTS. On prévoit de préférence, les empilements à base desquels l'élément résistif 31 et le sélecteur 33 sont formés de sorte à avoir des écarts de seuils de basculement VthSET1-VthSET2 et VthRESET-VthSET1 importants et par exemple supérieurs à 100mV, de préférence d'au moins 500mV et avantageusement de l'ordre de 1V.

A titre d'exemple pour une cellule mémoire avec un sélecteur OTS à base de GSSN de 5 nm d'épaisseur et un élément de mémorisation de type OxRAM, en particulier formé d'un empilement de HfO2 et de Ti et de dimension critique de la zone active de l'ordre de 80 nm, une tension de seuil Vth = VthOTS + 0.2 V (VthOTS étant le seuil de basculement vers un état passant du sélecteur) peut être prévue pour une cellule programmée à un état correspondant à une résistance par exemple de 1kΩ. Pour une cellule programmée à un état correspondant à une résistance par exemple de 10 kΩ, on peut avoir Vth = VthOTS + 0.7 V, tandis que pour une cellule programmée à un état correspondant à une résistance par exemple de 10 kΩ, on peut avoir Vth = VthOTS + 2.4V.

Le procédé de lecture précédemment décrit n'est toutefois pas limité à une lecture de cellules programmées à un état de programmation parmi 3 états de programmation distincts et s'applique à une lecture sur des cellules pour lesquelles le nombre d'états résistifs de programmation est supérieur à trois. Le nombre d'états de programmation susceptibles d'être codés sur une même cellule est typiquement limité et prévu inférieur à une limite donnée, par exemple de 15 ou 10 ou avantageusement 4 permettant de conserver un écart ΔVth des tensions de commutation suffisant.

Dans un autre exemple de réalisation illustré sur la figure 6, l'opération de lecture est susceptible cette fois de comporter trois sous-étapes de lecture de courant successives afin de distinguer un niveau ou de programmation entre quatre états de programmation distincts susceptibles d'être mémorisés dans une cellule mémoire RRAM que l'on souhaite lire.

Dans cet exemple, on applique une séquence de tensions de lecture, Vread1, Vread2, Vread3 dans un ordre croissant de niveaux de tension de lecture.

On applique ainsi tout d'abord à une cellule une première tension de lecture Vread1, comprise entre une tension de seuil VthSET3 et une autre tension de seuil VthSET2 (en particulier VthSET3 < Vread1 < VthSET2) et on fait l'acquisition d'une première valeur de courant Iread1 résultant de l'application de cette première tension de lecture Vread1. Puis, on applique une deuxième tension de lecture Vread2, supérieure à la première tension de lecture Vread1 et comprise entre une tension de seuil VthSET2 et une autre tension de seuil VthSET1 (en particulier VthSET2 < Vread2 < VthSET1) et on fait l'acquisition d'une deuxième valeur de courant Iread2 résultant de l'application de cette deuxième tension de lecture Vread2.

Ensuite, on applique une troisième tension de lecture Vread3, supérieure à la deuxième tension de lecture Vread2 et comprise entre une tension de seuil VthSET1 et une autre tension de seuil VthRESET (en particulier VthSET1 < Vread3 < VthRESET) et on fait l'acquisition d'une troisième valeur de courant Iread3 de lecture résultant de l'application de cette troisième tension de lecture Vread2.

On additionne ensuite la première valeur de courant Iread1, la deuxième valeur de courant Iread2 et la troisième valeur de courant Iread3.

En fonction de la valeur de la somme Iread1+ Iread2+ Iread3 obtenue, on associe à la cellule mémoire lue un état de programmation donné parmi les quatre états de programmation auxquels cette cellule est susceptible d'être programmée.

Le tableau ci-dessous répertorie des résultats possibles d'une telle opération de lecture avec trois sous-étapes successives de lecture « Read1 », « Read2 », « Read3 » de courant traversant une cellule consécutivement à l'application respectivement d'une première tension de lecture puis d'une deuxième tension de lecture, puis d'une troisième tension de lecture dans un cas théorique où l'on considère Ilimit = 100µA et où IffOTS = 0µA.

La somme obtenue permet ici de distinguer de manière précise 4 niveaux de courant correspondant chacun à l'un des 4 états de programmation à laquelle la cellule résistive est susceptible d'être programmée.

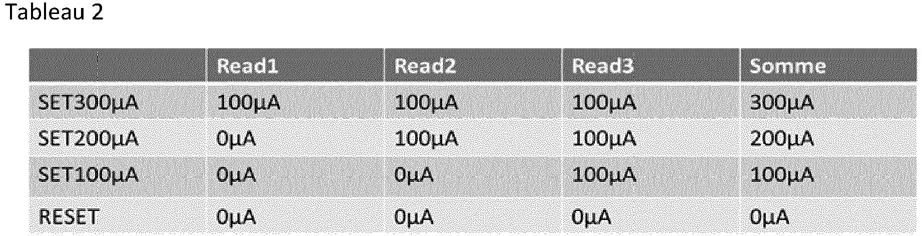

Dans l'un ou l'autre des exemples qui viennent des décrits, on applique une succession de tensions de lecture par ordre croissant de tensions.

Toutefois, une séquence différente de tensions de lectures peut être prévue pour mettre en œuvre l'opération de lecture.

Ainsi, on peut en particulier prévoir d'appliquer successivement des tensions de lecture distinctes et décroissantes.

Dans l'un ou l'autre des exemples d'opération de lecture qui viennent d'être donnés, on effectue à chaque sous étape la lecture d'un courant de lecture lorsqu'une nouvelle tension de lecture est imposée et on détermine à chaque fois le niveau du courant de lecture et/ou si celui-ci correspond à celui d'un état bloqué du sélecteur ou un état passant du sélecteur.

Puis, à partir de cette détermination de chaque courant on évalue l'état dans lequel a été programmé l'élément de mémorisation. Ainsi, on effectue par exemple une somme de tous les courants de lecture afin de déterminer l'état de programmation de la cellule soumise à l'opération de lecture.

Selon une variante de réalisation, on peut, dans certains cas, déterminer l'état d'une cellule programmée selon un codage multi-niveaux, avant d'avoir appliqué la séquence complète de tension de lecture.

C'est le cas notamment lorsque l'on suit un ordre décroissant d'application des tensions de lecture Vread.

Ainsi, on peut commencer par appliquer la tension de lecture la plus élevée. Si l'on se réfère à l'exemple qui vient d'être décrit, on applique en premier lieu la tension Vread1 telle que VthSET1 < Vread 1 < VthRESET afin d'obtenir une valeur de courant.

On lit alors cette valeur de courant.

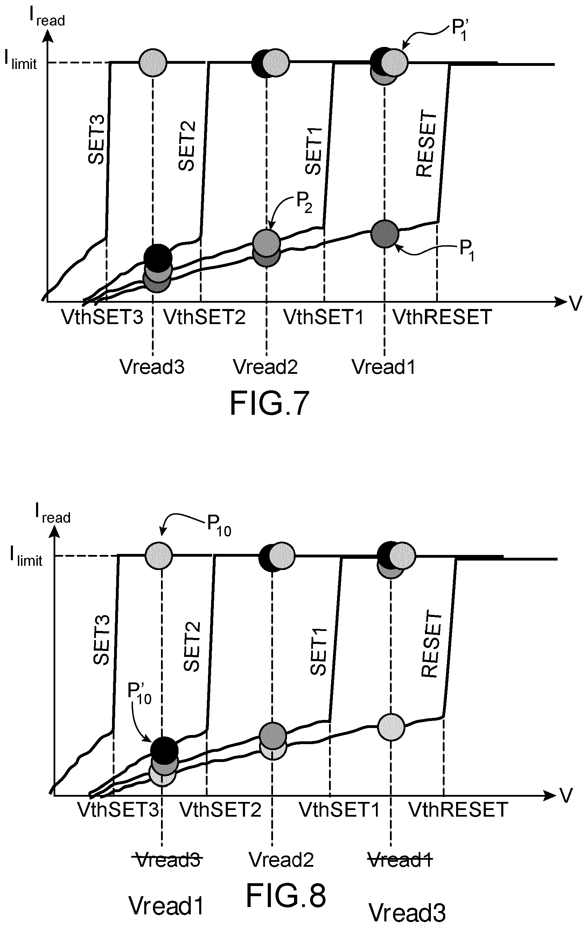

Dans le cas (point P1 sur la figure 7) où le courant lu correspond à un niveau de courant de fuite du sélecteur loffOTS et que le courant lu est ainsi inférieur à un seuil donné, correspondant par exemple à une valeur donnée de courant de fuite, on peut déclencher l'arrêt de la lecture.

En effet, dans ce cas, la valeur de courant lue correspond alors à l'état de programmation le plus élevé parmi les états de programmation à laquelle la cellule mémoire est susceptible d'être programmée. On peut alors directement associer la valeur de courant lue à la tension Vread1 à l'état de programmation correspondant au niveau de courant de programmation le plus élevé. La lecture peut alors être stoppée.

Dans un autre cas (points P'1 sur la figure 7) où le niveau de courant lu consécutivement à l'application de la première tension Vread1 de lecture est supérieur au seuil donné, on peut poursuivre la lecture.

On applique alors à la cellule mémoire 3 une deuxième tension de lecture V_{read2} cette fois moins élevée que la précédente et appartenant à une gamme de tensions plus basses que la première tension de lecture V_{read1}. Dans cet exemple, V_{read2} est telle que VthSET2 < V_{read2} < VthSET1.

Dans le cas où le niveau de courant lu consécutivement à l'application de la deuxième tension Vread2 correspond à celui d'un courant de fuite loffOTS du sélecteur (point P2 sur la figure 7), et que le courant lu est en particulier inférieur au seuil donné I_{SHRS} de courant, on peut stopper l'opération de lecture.

On peut alors directement associer la valeur de courant lue à la tension Vread2 à un deuxième état programmation correspondant au deuxième niveau de courant de programmation le plus élevé après celui le plus élevé.

Plus généralement, lorsqu'on suit une séquence décroissante de tension de lecture, dès lors que le courant lu est inférieur au seuil donné de courant, on peut arrêter la lecture, ce qui permet de réaliser un gain de temps de traitement pour effectuer une opération de lecture.

Le tableau ci-dessous répertorie des résultats possibles d'une opération de lecture du type de celle décrite précédemment sur une cellule mémoire programmée à un état de programmation donné parmi quatre états de programmation distincts, SET300µA, SET100µA, SET200µA, RESET dans un cas théorique où l'on considère
Ilimit = 100µA et où IffOTS = 0µA.

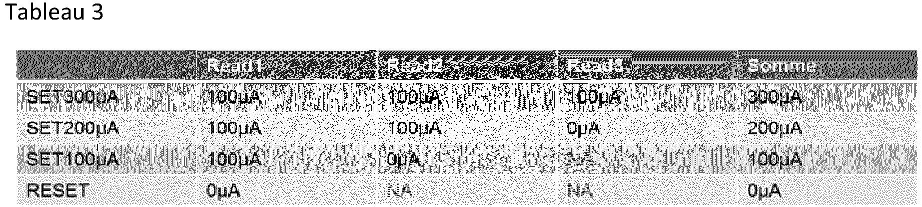

En variante, illustrée sur la caractéristique tension courant de la figure 8, lorsque l'on suit un ordre croissant d'application des tensions de lecture, on peut également, dans certains cas, déterminer l'état de programmation d'une cellule programmée selon un codage multi-niveaux, avant d'avoir effectué la somme totale des courants lus ou avant d'avoir appliqué une séquence complète de tensions de lecture.

Ainsi, on peut commencer par appliquer la tension de lecture la plus faible. On applique en premier lieu ainsi une première tension Vread1 telle que VthSET3 < Vread1 < VthSET2 afin d'obtenir une valeur de courant.

On lit alors cette valeur de courant.

Dans le cas (point P10 sur la figure 8) où le courant lu correspond au courant Ilimit lorsque le sélecteur est passant, on peut stopper la lecture.

On peut alors directement associer la valeur de courant lue à la tension Vread1 à un état de programmation correspondant au niveau de courant de programmation le plus faible. Dans d'autres cas (points P'10 sur la figure 8) où le niveau de courant lu consécutivement à l'application de la première tension vread1 de lecture, correspond à celui d'un courant de fuite loffOTS on peut poursuivre la lecture.

Ainsi, lorsqu'on suit une séquence croissante de tension de lecture, avec Vread1 < Vread2 < Vread3, dès lors que le courant lu est supérieur au seuil donné de courant, on peut arrêter la lecture, ce qui permet également de réaliser un gain de temps de traitement et par la même occasion de limiter la consommation.

Une telle manière de réaliser l'opération de lecture peut permettre de se passer d'une portion spécifique de circuit destinée à réaliser une somme de courant et/ou d'éviter de devoir nécessairement réaliser une conversion analogique numérique de la somme de courants.

En variante, des exemples de séquence d'application de tensions de lecture croissantes ou décroissantes, on peut envisager une séquence de type dichotomique, en particulier lorsque l'on effectue une application séquentielle d'un nombre important de tensions de lecture distinctes.

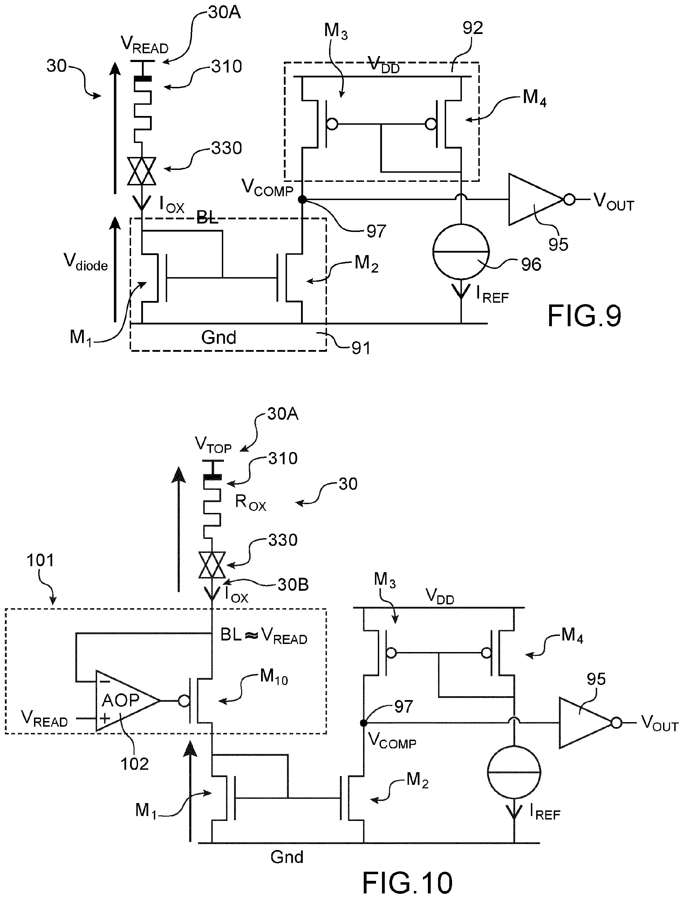

Une détermination du courant de lecture traversant la cellule consécutivement à l'application d'une tension de lecture Vread et une détection binaire permettant de réaliser une distinction entre un niveau de courant Ilimit correspondant au courant lorsque le sélecteur et l'élément de mémorisation sont passants et un niveau de courant correspondant au courant de fuite de fuite loffOTS lorsque le sélecteur est bloqué peut être réalisée par exemple à l'aide d'un circuit de lecture tel qu'illustré sur la figure 9.

Le circuit de lecture s'applique ici à une cellule multi-niveaux de type 1S-1R en particulier avec un élément 310 de mémorisation résistif ayant une structure de type OxRAM en série avec un sélecteur 330 de type OTS.

Le courant de lecture noté lox est comparé à un seuil sous forme d'un courant de référence Iref produit par un générateur 96, avec Iref par exemple de l'ordre de 1 nA. En fonction de la valeur du courant lox traversant la cellule 30, varie un potentiel Vcomp d'un nœud 97 couplé à une entrée d'un inverseur 95. Le nœud 97 est agencé entre un premier étage 91 à transistors et un deuxième étage 92 à transistors. Le premier étage 91 reçoit le courant lox et est formé de transistors M1, M2 réalisant un miroir de courant, tandis que le deuxième étage 92 à transistors M3, M4 est également monté en miroir de courant et est relié au générateur 96. On compare l'image du courant lox entrant dans le premier étage avec celui de référence Iref de référence. La sortie de l'inverseur 95 produit un signal V_{OUT} binaire dont l'état diffère suivant que le courant de lecture lox est à un niveau correspondant à Ilimit, ou que lox est à un niveau correspondant à loffOTS.

Pour appliquer des tensions de lectures différentes, on module la tension de lecture en faisant varier un potentiel appliqué sur un élément conducteur couplé apte à être couplé à une première extrémité 30A de la cellule 30.

A titre d'exemple, on peut avoir un courant lox traversant la cellule de l'ordre de 10 µA lorsque le sélecteur est passant (ON) et de l'ordre de 100 nA lorsque le sélecteur est à l'état bloqué (OFF). Une tension Vdiode du transistor M₁ est susceptible de varier de l'ordre de 200 mV entre de tels niveaux de courant. On tient compte de préférence de cette tension Vdiode pour prévoir l'écart de tension entre deux tensions de lecture successives Vread1 et Vread2 de niveaux distincts, en prévoyant de préférence |Vread1 - Vread2 | > 200 mV.

Une variante de circuit de lecture illustrée sur la figure 10 prévoit d'introduire en outre un étage 101 formant une boucle de régulation de tension en sortie de la cellule 30, entre cette dernière et le premier étage à transistors M1, M2. La boucle de régulation est ici formée au moyen d'un amplificateur 102 dont l'entrée non-inverseuse reçoit la tension de lecture Vread susceptible d'être modulée et dont l'entrée inverseuse est couplée à un élément conducteur, typiquement une ligne de bit BL reliée à une deuxième extrémité 30B de la cellule 30 et recevant le courant lox. La sortie de l'amplificateur 102 est couplée à la grille d'un transistor M10, ici de type PMOS. Le transistor M10 est ici monté en drain commun et n'influe pas sur le gain de l'étage d'amplification. Le potentiel de drain du transistor M10 est modulé sans modifier la valeur du courant dans la branche.

Un tel agencement facilite l'application de tensions de lectures distinctes, la tension de lecture étant cette fois appliquée sur une deuxième extrémité 30B de la cellule 30 opposée à la première 30A sur laquelle elle est appliquée dans l'exemple de réalisation précédent. La première extrémité 30A est cette fois mise à un potentiel V_{TOP} fixe.

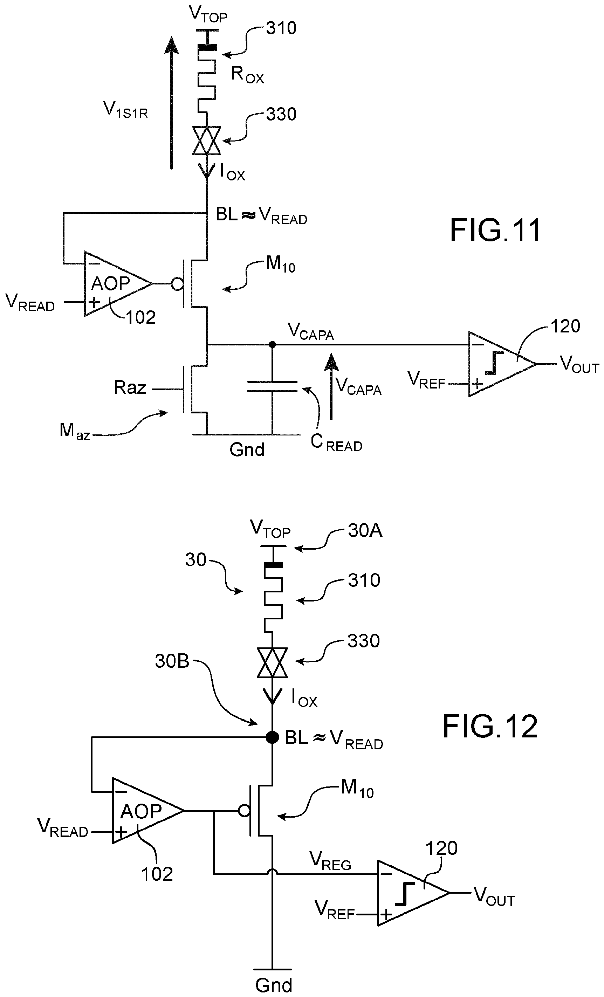

Une autre variante de circuit de lecture, illustrée sur la figure 11, reprend l'étage 101 de régulation de tension de l'exemple de réalisation précédemment décrit. Le courant lox traversant la cellule 30 est ici intégré en chargeant une capacité Cread de lecture, elle-même couplée à un comparateur 120 de tension produisant un signal Vout de sortie binaire. Une tension Vcapa aux bornes de la capacité Cread est l'image du courant traversant la cellule lox avec, en particulier, Vcapa = (1/Cread)* *∫ Iox.* Cette tension Vcapa, ici injectée en entrée non-inverseuse du comparateur 120 est comparée à un seuil Vref afin de distinguer un cas dans lequel le courant lox est à un niveau correspondant à un courant Ilimit lorsque le sélecteur 330 est passant et un cas dans lequel le courant lox est à un niveau correspondant à un courant loffOTS lorsque le sélecteur 330 est bloqué.

Du fait de l'étage de régulation 101, pendant une sous étape de lecture de courant à une tension Vread, l'élément conducteur BL relié à la cellule 30 est maintenu à un potentiel de l'ordre de la tension de lecture Vread malgré la variation de tension Vcapa aux bornes de la capacité Cread de lecture. Là encore, un tel agencement facilite la mise en œuvre de l'application d'une séquence de tensions de lectures Vread1, Vread2, Vread3, à des niveaux différents l'une de l'autre lors de sous-étapes successives d'une opération de lecture. Un transistor Maz de remise à zéro dont la grille est commandée par un signal de remise à zéro Raz permet de décharger la capacité Cread entre deux sous-étapes de lecture de courant à des niveaux de tension de lectures distincts.

Selon une autre variante illustrée sur la figure 12, le résultat d'une lecture d'un courant circulant dans la cellule consécutive à l'application d'une tension Vread=Vread1 ou Vread2 ou Vread3 est toujours produit en sortie d'un comparateur 120 produisant le signal de sortie Vout binaire. Pour effectuer la comparaison par rapport au seuil de tension Vref, on utilise cette fois une tension Vreg en sortie de l'amplificateur 102 de l'étage 101 de régulation.

Il y a typiquement un écart d'au moins deux décades entre un courant à l'état passant du sélecteur 330 et un courant à l'état bloqué du sélecteur 330. Du fait de cet écart, une sortie Vreg de l'amplificateur 102 de l'étage 101 de régulation donne une image du courant *Iₒₓ* traversant la cellule donc de l'état passant ou bloqué du sélecteur. En effet, lorsque *Iₒₓ* est à un niveau « faible » correspondant à un état bloqué du sélecteur 330, la sortie *V_{REG}* est à un niveau élevé de sorte que la sortie Vout du comparateur 120 est à un niveau correspondant par exemple à un '0' logique. Lorsque le courant *I_{OX}* est à un niveau « élevé », *V_{REG}* sera relativement faible permettant à la sortie Vout du comparateur 120 de basculer à un niveau logique opposé et correspondant par exemple à un '1' logique. En variante on peut également prévoir de mettre en œuvre une régulation sur l'extrémité 30A de la cellule dans cet exemple mise au potentiel Vtop fixe, afin de pouvoir faire varier ce potentiel VTOP d'une sous étape de lecture à l'autre.

Une programmation multi-niveaux d'une cellule mémoire peut être réalisée suivant différentes manières. Des impulsions de courant de programmation permettant d'utiliser le dispositif en tant que mémoire. Une impulsion dite de RESET est une impulsion de programmation pour amener le dispositif dans un état de programmation de haute résistivité HRS en appliquant une tension de seuil VthRESET correspondante.

Selon une première configuration, le dispositif est déjà dans un état de programmation HRS.

Dans ce cas, pour qu'un changement de tension de seuil à par exemple VthSET1 ou VthSET2,... se produise, il est nécessaire qu'un courant de programmation suffisant circule dans la cellule. Le courant de programmation est sous forme d'une impulsion de durée très courte et une combinaison de la présence d'un courant de programmation significatif et d'un choix approprié de durée de rampe de descente importante de l'impulsion permet de modifier la tension de seuil de la cellule.

Par durée « très courte » on entend typiquement entre 10ns et 1µs, par exemple 100ns. Par courant de programmation « significatif » on entend typiquement entre 50µA et 350µA. Par rampe de descente « importante » on entend typiquement 10 fois inférieure à la durée d'impulsion par exemple de 10ns de rampe pour une durée d'impulsion de 100ns.

Deux méthodes distinctes peuvent être utilisées pour ajuster la tension de seuil Vth d'une cellule 1S-1R.

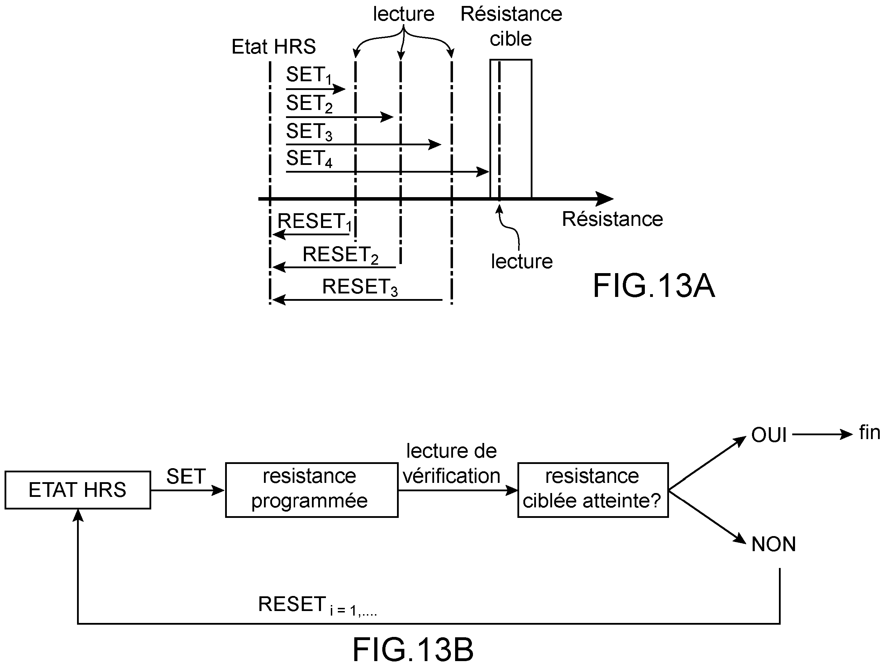

Selon une première méthode illustrée sur le schéma de la figure 13A et sur l'organigramme procédural de la figure 13B, on émet une première impulsion de courant SET₁ afin de programmer la résistance de la cellule. On effectue ensuite une lecture de vérification. Si suite à cette lecture de vérification, on détecte que la résistance ciblée est atteinte, la programmation est terminée. Dans le cas contraire, on applique une impulsion RESET₁ pour mettre la cellule dans un état HRS. On réitère alors avec une impulsion de courant SET₂ d'intensité plus élevée que celle de la première impulsion SET₁. L'impulsion de courant SET est typiquement de polarité opposée à celle de type RESET pour l'effacement.

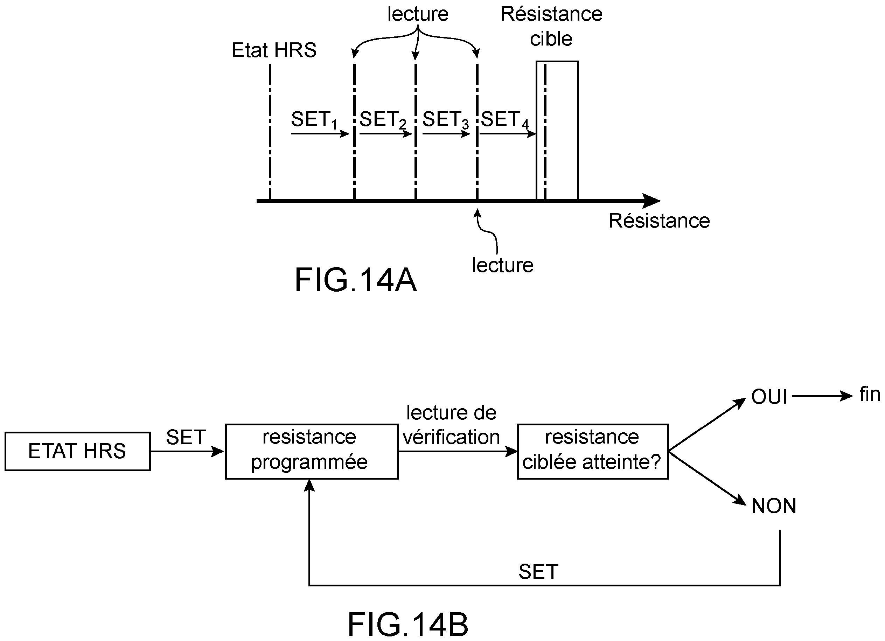

Selon une deuxième méthode illustrée sur les figures 14A et 14B, on émet une première impulsion de courant SET₁ afin de programmer la résistance de la cellule. On effectue ensuite une lecture de vérification. Si cette lecture de vérification indique que la résistance ciblée est atteinte, la programmation est terminée. Dans le cas contraire, on applique une nouvelle impulsion SET₂ de programmation dont l'intensité peut être cette fois de même intensité ou éventuellement plus faible que la première impulsion SET₁.

En variante, plutôt que de programmer une cellule mémoire avec des impulsions de programmation SET de niveaux différents pour ajuster la tension de seuil Vth, on peut réaliser des effacements à différents niveaux de tension RESET. On peut ainsi moduler la tension de RESET typiquement négative appliquée aux bornes de la cellule, qui contrôle la résistance de la cellule en plus cette tension est élevée, plus la cellule sera effacée donc plus la résistance associée sera élevée.

Outre leur caractère non-volatile, les mémoires résistives peuvent présenter une importante densité d'intégration qui les rend des candidates pour l'implémentation de circuit neuro-morphiques formés d'un ensemble de neurones artificiels. De tels circuits peuvent être utilisés dans de domaines tels que par exemple le traitement du signal, la classification de données, la reconnaissance d'images. Un procédé de commande de cellules mémoire résistives selon l'invention peut donc s'appliquer également à de tels circuits neuro-morphiques à synapses résistives et programmables sur un nombre supérieur à deux d'états de programmation distincts.

## Revendications

1. Dispositif mémoire formé de cellules mémoires résistives (3) dotées chacune d'un élément (31, 310) de mémoire résistive associé en série à un sélecteur (33, 330), chaque cellule implémentant un codage dit « multi-niveaux » et étant programmée à un état de programmation donné (3i) parmi k avec k > 2 états de programmation possibles,
le dispositif comprenant un circuit de lecture configuré pour, lors d'une opération de lecture sur une cellule donnée : appliquer une séquence d'au moins deux tensions de lecture (Vread1, Vread2, Vread3) successives et différentes à la cellule donnée,
le circuit de lecture étant configuré de sorte que ladite séquence comprend l'application d'une première tension de lecture (Vread1) à la cellule donnée, la première tension de lecture (Vread1) appartenant à une première gamme de tensions entre une première tension de seuil et une deuxième tension de seuil, et étant sélectionnée parmi un ensemble de tensions de lecture d'une séquence de tensions de lecture différentes (Vread1, Vread2, Vread3) auxquelles une cellule de ladite mémoire est susceptible d'être soumise lors de ladite opération de lecture, puis l'application d'une deuxième tension de lecture (Vread2), de ladite séquence de tensions de lecture, la deuxième tension de lecture étant différente de la première tension de lecture et appartenant à une deuxième gamme de tensions entre la deuxième tension de seuil et une troisième tension de seuil, l'état de programmation donné étant déterminé en fonction de valeurs respectives d'un premier courant de lecture (Iread1) traversant ladite cellule donnée résultant de l'application de ladite première tension de lecture (Vread1) et d'un deuxième courant de lecture (Iread2) traversant ladite cellule donnée consécutivement à l'application de ladite deuxième tension de lecture (Vread2), **caractérisé en ce que** le dispositif mémoire comprend additionnellement :
ledit état de programmation donné étant déterminé en fonction de la valeur d'une somme entre ledit premier courant de lecture (Iread1) et ledit deuxième courant de lecture (Iread2), le circuit de lecture étant configuré en outre pour détecter à chaque tension de lecture appliquée de ladite séquence si un courant de lecture (Iread1) traversant ladite cellule donnée et résultant de l'application de ladite de tension de lecture correspond à un premier niveau de courant de fuite (loffOTS) du sélecteur (33) lorsque ce sélecteur se trouve dans un état bloqué ou si le courant de lecture correspond à un deuxième niveau de courant (Ilimit) lorsque le sélecteur se trouve dans un état passant.

2. Dispositif mémoire selon la revendication 1, dans lequel lors de ladite opération de lecture la séquence de tensions de lecture différentes (Vread1, Vread2, Vread3) est appliquée par ledit circuit de lecture à ladite cellule mémoire donnée selon un ordre croissant de tensions de lecture ou selon un ordre décroissant de tensions de lecture.

3. Dispositif mémoire selon l'une des revendications 1 ou 2, dans lequel le sélecteur (33) est un commutateur à deux terminaux, en particulier de type interrupteur à seuil ovonique (OTS).

4. Dispositif mémoire selon l'une des revendications 1 à 3, dans lequel l'élément (31) de mémoire résistive est un élément de mémoire résistive à base d'oxyde (OxRAM).

5. Dispositif mémoire selon l'une des revendications 1 à 4, le circuit de lecture étant doté d'un amplificateur (102) ayant une entrée non-inverseuse à laquelle la tension de lecture (Vread) est appliquée et une entrée inverseuse connectée au drain d'un transistor (M10) monté en drain commun et couplé en sortie du sélecteur (330).

6. Dispositif mémoire selon l'une des revendications 1 à 5, dans lequel le circuit de lecture est configuré pour comparer un courant image issu d'un premier miroir de courant (91) recevant un courant issu du sélecteur à un autre courant issu d'un deuxième miroir de courant (92) auquel un courant de référence (IREF) est appliqué.

7. Dispositif mémoire selon l'une des revendications 1 à 6, le circuit de lecture est doté d'un comparateur (120) pour comparer une tension (VREG) en sortie de l'amplificateur (102) avec une tension de référence (VREF).

8. Dispositif mémoire selon l'une des revendications 1 à 5, dans lequel le circuit de lecture est doté d'une capacité d'intégration (C_{READ}) chargée par un courant image d'un courant issu du sélecteur (330), le circuit de lecture étant configuré pour lors de l'opération de lecture selon ladite séquence de tensions décharger la capacité d'intégration (C_{READ}) consécutivement à l'application d'une première tension de lecture (V_{READ1}) de ladite séquence et préalablement à l'application d'une deuxième tension de lecture (V_{READ2}) suivant ladite première tension de lecture dans ladite séquence de tensions.

9. Procédé de commande d'un dispositif selon l'une des revendications 1 à 8, comprenant lors d'opération de lecture d'un état de programmation donné d'une cellule mémoire résistive donnée (3i) parmi lesdites cellules mémoires résistives, des étapes consistant à :
- appliquer une première tension de lecture (Vread1) à la cellule donnée, la première tension de lecture (Vread1) appartenant à une première gamme de tensions entre une première tension de seuil et une deuxième tension de seuil, et étant sélectionnée parmi un ensemble de tensions de lecture d'une séquence de tensions de lecture différentes (Vread1, Vread2, Vread3) auxquelles une cellule de ladite mémoire est susceptible d'être soumise lors de ladite opération de lecture, puis
- appliquer une deuxième tension de lecture (Vread2), de ladite séquence de tensions de lecture, la deuxième tension de lecture étant différente de la première tension de lecture et appartenant à une deuxième gamme de tensions entre la deuxième tension de seuil et une troisième tension de seuil, l'état de programmation donné étant déterminé en fonction de valeurs respectives d'un premier courant de lecture (Iread1) traversant ladite cellule donnée résultant de l'application de ladite première tension de lecture (Vread1) et d'un deuxième courant de lecture (Iread2) traversant ladite cellule donnée consécutivement à l'application de ladite deuxième tension de lecture (Vread2), ledit état de programmation donné étant déterminé en fonction de la valeur d'une somme entre ledit premier courant de lecture (Iread1) et ledit deuxième courant de lecture (Iread2),
ou,
- déclencher la fin à l'opération de lecture :
lorsque la première tension de lecture (Vread1) est la tension la plus élevée de ladite séquence (Vread1, Vread2,...) de tensions et que le premier courant traversant ladite cellule donné et consécutif à l'application de ladite première tension de lecture (Vread1) correspond à un niveau de courant de fuite (loffOTS) du sélecteur (33) lorsque ce sélecteur se trouve dans un état bloqué, ou bien
lorsque la première tension de lecture (Vread1) est la tension la plus faible de ladite séquence (Vread1, Vread2,...) de tensions et que le premier courant correspond à un niveau de courant (Ilimit) lorsque le sélecteur se trouve dans un état passant.

10. Procédé de commande selon la revendication 9, comprenant en outre, après application de la première tension de lecture (Vread1) et préalablement à l'application de la deuxième tension de lecture (Vread2) ou au déclenchement de la fin de l'opération de lecture :
- une étape de détection binaire consistant à déterminer si le premier courant de lecture (Iread1) correspond à un niveau de courant de fuite (loffOTS) du sélecteur (33) lorsque ce sélecteur (33, 330) se trouve dans un état bloqué ou bien si le premier courant correspond à un niveau de courant (Ilimit) lorsque le sélecteur (33, 330) se trouve dans un état passant, en particulier par comparaison du premier courant de lecture ou d'une image du premier courant de lecture sous forme d'une tension (Vcapa, Vcomp, Vreg) ou d'un courant à un seuil donné (Vref, Iref).

11. Procédé de commande selon l'une des revendications 9 ou 10, dans lequel l'opération de lecture comprend en outre, après l'étape consistant à appliquer la deuxième tension de lecture (Vread2) :
- appliquer une troisième tension de lecture (Vread3), de ladite séquence de tensions de lecture, la troisième tension de lecture étant différente desdites première tension de lecture (Vread1) et deuxième tension de lecture (Vread2) et appartenant à une troisième gamme de tensions entre la troisième tension de seuil et une quatrième tension de seuil, ou
- déclencher la fin à l'opération de lecture :
lorsque la deuxième tension de lecture (Vread2) est, hormis la première tension de lecture la tension la plus élevée de ladite séquence (Vread1, Vread2, Vread3) de tensions et que le deuxième courant de lecture correspond à un niveau de courant de fuite (loffOTS) du sélecteur (33) lorsque ce sélecteur se trouve dans un état bloqué, ou bien
lorsque la deuxième tension de lecture (Vread2) est, hormis la première tension de lecture, la tension la plus faible de ladite séquence (Vread1, Vread2,...) de tensions et que le deuxième courant de lecture correspond à un niveau de courant (Ilimit) du sélecteur (33) lorsque le sélecteur se trouve dans un état passant.

12. Procédé de commande selon la revendication 11, dans lequel l'opération de lecture comprend en outre, après application de la troisième tension (Vread3) de lecture :
- une étape de détermination dudit état de programmation donné en fonction de la valeur d'une somme entre ledit premier courant de lecture, ledit deuxième courant de lecture, et un troisième courant traversant ladite cellule donné consécutivement à l'application de ladite troisième tension de lecture (Vread3).

13. Procédé de commande selon l'une des revendications 11 ou 12, comprenant en outre, après application de la deuxième tension de lecture et préalablement à l'application de la troisième tension de lecture ou au déclenchement de la fin de l'opération de lecture, une étape de détection binaire consistant à déterminer si le deuxième courant de lecture correspond à un niveau de courant de fuite (loffOTS) du sélecteur (33) lorsque ce sélecteur se trouve dans un état bloqué ou bien si le deuxième courant correspond à un niveau de courant (Ilimit) lorsque le sélecteur se trouve dans un état passant.

14. Procédé de commande selon l'une des revendications 9 à 13, dans lequel préalablement à l'opération de lecture, on effectue une programmation de l'état donné en appliquant une succession d'impulsions de courant à la cellule donnée.

## Patentansprüche

1. Speichervorrichtung, die aus resistiven Speicherzellen (3) gebildet wird, die jeweils mit einem resistiven Speicherelement (31, 310) ausgestattet sind, das in Reihe mit einem Wahlschalter (33, 330) verbunden ist, wobei jede Zelle eine sogenannte "Mehrstufen"-Codierung implementiert und auf einen bestimmten Programmierzustand (3i) von k, wobei k > 2, möglichen Programmierzuständen programmiert ist,
wobei die Vorrichtung eine Leseschaltung umfasst, die so konfiguriert ist, dass sie bei einem Lesevorgang an einer gegebenen Zelle eine Sequenz von mindestens zwei aufeinanderfolgenden und unterschiedlichen Lesespannungen (Vread1, Vread2, Vread3) an die bestimmte Zelle anlegt,
wobei die Leseschaltung so konfiguriert ist, dass die Sequenz das Anlegen einer ersten Lesespannung (Vread1) an die gegebene Zelle, wobei die erste Lesespannung (Vread1) zu einem ersten Spannungsbereich zwischen einer ersten Schwellenspannung und einer zweiten Schwellenspannung gehört und aus einer Reihe von Lesespannungen einer Sequenz unterschiedlicher Lesespannungen (Vread1, Vread2, Vread3) ausgewählt wird, denen eine Zelle des Speichers während des Lesevorgangs ausgesetzt sein kann, und dann das Anlegen einer zweiten Lesespannung (Vread2) der Sequenz von Lesespannungen umfasst, wobei die zweite Lesespannung sich von der ersten Lesespannung unterscheidet und zu einem zweiten Spannungsbereich zwischen der zweiten Schwellenspannung und einer dritten Schwellenspannung gehört, wobei der gegebene Programmierzustand in Abhängigkeit von den jeweiligen Werten eines ersten Lesestroms (Iread1), der durch die gegebene Zelle fließt, die sich aus dem Anlegen der ersten Lesespannung (Vread1) ergibt, und eines zweiten Lesestroms (Iread2) bestimmt wird, der infolge des Anlegens der zweiten Lesespannung (Vread2) durch die gegebene Zelle fließt, **dadurch gekennzeichnet, dass** die Speichervorrichtung zusätzlich Folgendes umfasst:
wobei der gegebene Programmierzustand in Abhängigkeit vom Wert einer Summe zwischen dem ersten Lesestrom (Iread1) und dem zweiten Lesestrom (Iread2) bestimmt wird, wobei die Leseschaltung ferner so konfiguriert ist, dass sie bei jeder angelegten Lesespannung der Sequenz erkennt, ob ein Lesestrom (Iread1), der durch die gegebene Zelle fließt und sich aus dem Anlegen der Lesespannung ergibt, einem ersten Leckstrompegel (IoffOTS) des Wahlschalters (33) entspricht, wenn sich dieser Wahlschalter in einem gesperrten Zustand befindet, oder ob der Lesestrom einem zweiten Strompegel (Ilimit) entspricht, wenn sich der Wahlschalter in einem leitenden Zustand befindet.

2. Speichervorrichtung nach Anspruch 1, wobei während des Lesevorgangs die Sequenz unterschiedlicher Lesespannungen (Vread1, Vread2, Vread3) von der Leseschaltung in einer aufsteigenden Reihenfolge von Lesespannungen oder in einer absteigenden Reihenfolge von Lesespannungen an die gegebene Speicherzelle angelegt wird.

3. Speichervorrichtung nach einem der Ansprüche 1 oder 2, wobei der Wahlschalter (33) ein Schalter mit zwei Klemmen, insbesondere vom Typ ovonischer Schwellenschalter (OTS), ist.

4. Speichervorrichtung nach einem der Ansprüche 1 bis 3, wobei das resistive Speicherelement (31) ein oxidbasiertes resistives Speicherelement (OxRAM) ist.

5. Speichervorrichtung nach einem der Ansprüche 1 bis 4, wobei die Leseschaltung mit einem Verstärker (102) ausgestattet ist, der einen nicht invertierenden Eingang, an den die Lesespannung (Vread) angelegt wird, und einen invertierenden Eingang aufweist, der mit dem Drain eines Transistors (M10) verbunden ist, der als gemeinsamer Drain montiert und mit dem Ausgang des Wahlschalters (330) gekoppelt ist.

6. Speichervorrichtung nach einem der Ansprüche 1 bis 5, wobei die Leseschaltung so konfiguriert ist, dass sie einen Bildstrom von einem ersten Stromspiegel (91), der einen Strom von dem Wahlschalter empfängt, mit einem anderen Strom von einem zweiten Stromspiegel (92) vergleicht, an den ein Referenzstrom (IREF) angelegt wird.

7. Speichervorrichtung nach einem der Ansprüche 1 bis 6, wobei die Leseschaltung mit einem Komparator (120) ausgestattet ist, um eine Spannung (VREG) am Ausgang des Verstärkers (102) mit einer Referenzspannung (VREF) zu vergleichen.

8. Speichervorrichtung nach einem der Ansprüche 1 bis 5, wobei die Leseschaltung mit einer Integrationskapazität (C_{READ}) ausgestattet ist, die durch einen Bildstrom eines Stroms von dem Wahlschalter (330) geladen wird, wobei die Leseschaltung so konfiguriert ist, dass sie während des Lesevorgangs gemäß der Spannungssequenz die Integrationskapazität (C_{READ}) infolge des Anlegens einer ersten Lesespannung (V_{READ1}) der Sequenz und vor dem Anlegen einer zweiten Lesespannung (V_{READ2}), die der ersten Lesespannung in der Spannungssequenz folgt, entlädt.

9. Verfahren zum Steuern einer Vorrichtung nach einem der Ansprüche 1 bis 8, das während des Lesevorgangs einen gegebenen Programmierzustand einer gegebenen resistiven Speicherzelle (3i) aus den resistiven Speicherzellen umfasst und aus folgenden Schritte besteht:
- Anlegen einer ersten Lesespannung (Vread1) an die gegebene Zelle, wobei die erste Lesespannung (Vread1) zu einem ersten Spannungsbereich zwischen einer ersten Schwellenspannung und einer zweiten Schwellenspannung gehört und aus einer Reihe von Lesespannungen einer Sequenz unterschiedlicher Lesespannungen (Vread1, Vread2, Vread3) ausgewählt wird, denen eine Zelle des Speichers während des Lesevorgangs ausgesetzt sein kann, dann
- Anlegen einer zweiten Lesespannung (Vread2) der Sequenz von Lesespannungen, wobei die zweite Lesespannung sich von der ersten Lesespannung unterscheidet und zu einem zweiten Spannungsbereich zwischen der zweiten Schwellenspannung und einer dritten Schwellenspannung gehört, wobei der gegebene Programmierzustand in Abhängigkeit von jeweiligen Werten eines ersten Lesestroms (Iread1), der durch die gegebene Zelle fließt und sich aus dem Anlegen der ersten Lesespannung (Vread1) ergibt, und eines zweiten Lesestroms (Iread2) bestimmt wird, der infolge des Anlegens der zweiten Lesespannung (Vread2) durch die gegebene Zelle fließt, wobei der gegebene Programmierzustand in Abhängigkeit vom Wert einer Summe zwischen dem ersten Lesestrom (Iread1) und dem zweiten Lesestrom (Iread2) bestimmt wird,
oder
- Auslösen des Endes des Lesevorgangs:
wenn die erste Lesespannung (Vread1) die höchste Spannung der Spannungssequenz (Vread1, Vread2,...) ist und der erste Strom, der durch die Zelle fließt und auf das Anlegen der ersten Lesespannung (Vread1) folgt, einem Leckstrompegel (loffOTS) des Wahlschalters (33) entspricht, wenn sich der Wahlschalter in einem gesperrten Zustand befindet, oder
wenn die erste Lesespannung (Vread1) die niedrigste Spannung der Spannungssequenz (Vread1, Vread2,...) ist und der erste Strom einem Strompegel (Ilimit) entspricht, wenn sich der Wahlschalter in einem leitenden Zustand befindet.

10. Steuerverfahren nach Anspruch 9, das ferner nach dem Anlegen der ersten Lesespannung (Vread1) und vor dem Anlegen der zweiten Lesespannung (Vread2) oder dem Auslösen des Endes des Lesevorgangs Folgendes umfasst:
- einen Schritt des binären Erkennens, der darin besteht, zu bestimmen, ob der erste Lesestrom (Iread1) einem Leckstrompegel (loffOTS) des Wahlschalters (33) entspricht, wenn sich der Wahlschalter (33, 330) in einem gesperrten Zustand befindet, oder ob der erste Strom einem Strompegel (Ilimit) entspricht, wenn sich der Wahlschalter (33, 330) in einem leitenden Zustand befindet, insbesondere durch das Vergleichen des ersten Lesestroms oder eines Bildes des ersten Lesestroms in Form einer Spannung (Vcapa, Vcomp, Vreg) oder eines Stroms mit einem bestimmten Schwellenwert (Vref, Iref).

11. Steuerverfahren nach einem der Ansprüche 9 oder 10, wobei der Lesevorgang nach dem Schritt des Anlegens der zweiten Lesespannung (Vread2) ferner Folgendes umfasst:
- Anlegen einer dritten Lesespannung (Vread3) der Sequenz von Lesespannungen, wobei die dritte Lesespannung sich von der ersten Lesespannung (Vread1) und der zweiten Lesespannung (Vread2) unterscheidet und zu einem dritten Spannungsbereich zwischen der dritten Schwellenspannung und einer vierten Schwellenspannung gehört, oder
- Auslösen des Endes des Lesevorgangs:
wenn die zweite Lesespannung (Vread2), außer der ersten Lesespannung, die höchste Spannung der Spannungssequenz (Vread1, Vread2, Vread3) ist und der zweite Lesestrom einem Leckstrompegel (loffOTS) des Wahlschalters (33) entspricht, wenn sich der Wahlschalter in einem gesperrten Zustand befindet, oder
wenn die zweite Lesespannung (Vread2), außer der ersten Lesespannung, die niedrigste Spannung der Spannungssequenz (Vread1, Vread2,...) ist und der zweite Lesestrom einem Strompegel (Ilimit) des Wahlschalters (33) entspricht, wenn sich der Wahlschalter in einem leitenden Zustand befindet.

12. Steuerverfahren nach Anspruch 11, wobei der Lesevorgang ferner nach Anlegen der dritten Lesespannung (Vread3) Folgendes umfasst:
- einen Schritt des Bestimmens des gegebenen Programmierzustands in Abhängigkeit vom Wert einer Summe zwischen dem ersten Lesestrom, dem zweiten Lesestrom und einem dritten Strom, der infolge des Anlegens der dritten Lesespannung (Vread3) durch die gegebene Zelle fließt.

13. Steuerverfahren nach einem der Ansprüche 11 oder 12, das ferner nach dem Anlegen der zweiten Lesespannung und vor dem Anlegen der dritten Lesespannung oder dem Auslösen des Endes des Lesevorgangs einen Schritt des binären Erkennens umfasst, der darin besteht, zu bestimmen, ob der zweite Lesestrom einem Leckstrompegel (loffOTS) des Wahlschalters (33) entspricht, wenn sich der Wahlschalter in einem gesperrten Zustand befindet, oder ob der zweite Strom einem Strompegel (Ilimit) entspricht, wenn sich der Wahlschalter in einem leitenden Zustand befindet.

14. Steuerverfahren nach einem der Ansprüche 9 bis 13, wobei vor dem Lesevorgang eine Programmierung des gegebenen Zustands durch Anlegen einer Folge von Stromimpulsen an die gegebene Zelle durchgeführt wird.

## Claims

1. Memory device formed by resistive memory cells (3) each provided with a resistive memory element (31, 310) associated in series with a selector (33, 330), each cell implementing a so-called "multi-level" coding and being programmed to a given programming state (3i) among k with k > 2 possible programming states,
the device comprising a read circuit configured, during a read operation on a given cell: to apply a sequence of at least two successive and different read voltages (Vread1, Vread2, Vread3) to the given cell,
the read circuit being configured such that said sequence comprises the application of a first read voltage (Vread1) to the given cell, the first read voltage (Vread1) belonging to a first range of voltages between a first threshold voltage and a second threshold voltage, and being selected from a set of read voltages of a sequence different read voltages (Vread1, Vread2, Vread3) to which a cell of said memory is likely to be subjected during said read operation, then the application of a second read voltage (Vread2) of said sequence of read voltages, the second read voltage being different from the first read voltage and belonging to a second range of voltages between the second threshold voltage and a third threshold voltage, the given programming state being determined as a function of respective values of a first read current (Iread1) passing through said given cell resulting from the application of said first read voltage (Vread1) and a second read current (Iread2) passing through said given cell following the application of said second read voltage (Vread2), **characterized in that** the memory device further comprises, said given programming state (3i) being determined as a function of the value of a sum between said first read current (Iread1) and said second read current (Iread2), the read circuit being further configured to detect at each applied read voltage of said sequence whether a read current (Iread1) passing through said given cell and resulting from the application of said read voltage corresponds to a first leakage current level (loffOTS) of the selector (33) when this selector is in an OFF state or whether the read current corresponds to a second current level (Ilimit) when the selector is in an ON state.

2. Memory device according to claim 1, wherein during said read operation the sequence of different read voltages (Vread1, Vread2, Vread3) is applied by said read circuit to said given memory cell according to an increasing order of read voltages or according to a decreasing order of read voltages.

3. Memory device according to any of the claims 1 or 2, wherein the selector (33) is a switch with two terminals, in particular an ovonic threshold switch (OTS).

4. Memory device according to any of the claims 1 to 3, wherein the resistive memory element (31) is an oxide-based resistive memory element (OxRAM).

5. Memory device according to any of the claims 1 to 4, the read circuit being provided with an amplifier (102) having a non-inverting input to which the read voltage (Vread) is applied and an inverting input connected to the drain of a transistor (M10) mounted in a common drain and coupled to the output of the selector (330).

6. Memory device according to any of the claims 1 to 5, wherein the read circuit is configured to compare an image current from a first current mirror (91) receiving a current from the selector to another current from a second current mirror (92) to which a reference current (IREF) is applied.

7. Memory device according to any of the claims 1 to 6, the read circuit is provided with a comparator (120) for comparing a voltage (VREG) at the output of the amplifier (102) with a reference voltage (VREF).

8. Memory device according to any of the claims 1 to 5, wherein the read circuit is provided with an integration capacity (C_{READ}) charged by an image current of a current from the selector (330), the read circuit being configured to discharge the integration capacity (C_{READ}) during the read operation according to said sequence of voltages following the application of a first read voltage (V_{READ1}) of said sequence and prior to the application of a second read voltage (V_{READ2}) following said first read voltage in said sequence of voltages.

9. Control method of a device according to any of the claims 1 to 8, comprising during the read operation of a given programming state a given resistance memory cell (3i) among said resistive memory cells, steps consisting of:
- applying a first read voltage (Vread1) to the given cell, the first read voltage (Vread1) belonging to a first range of voltages between a first threshold voltage and a second threshold voltage, and being selected from a set of read voltages of a sequence of different read voltages (Vread1, Vread2, Vread3) to which a cell of said memory is likely to be subjected during said read operation, then
- applying a second read voltage (Vread2), of said sequence of read voltages, the second read voltage being different from the first read voltage and belonging to a second voltage range between the second threshold voltage and a third threshold voltage, the given programming state being determined as a function of respective values of a first read current (Iread1) passing through said given cell resulting from the application of said first read voltage (Vread1) and a second read current (Iread2) traversing said given cell following the application of said second read voltage (Vread2),
or,
- triggering the end of the read operation:
when the first read voltage (Vread1) is the highest voltage of said sequence (Vread1, Vread2,...) of voltages and the first current traversing said given cell and following the application of said first read voltage (Vread1) corresponds to a leakage current level (loffOTS) of the selector (33) when this selector is in an OFF state, or
when the first read voltage (Vread1) is the lowest voltage of said sequence (Vread1, Vread2,...) of voltages and the first current corresponds to a current level (Ilimit) when the selector is in an ON state.

10. Control method according to claim 9, further comprising, after applying the first read voltage (Vread1) and prior to the application of the second read voltage (Vread2) or triggering the end of the read operation:
- a binary detection step consisting of determining whether the first read current (Iread1) corresponds to a leakage current level (loffOTS) of the selector (33) when this selector (33, 330) is in an OFF state or whether the first current corresponds to a current level (Ilimit) when the selector (33, 330) is in an ON state, in particular by comparing the first read current or an image of the first read current as a voltage (Vcapa, Vcomp, Vreg) or a current to a given threshold (Vref, Iref).

11. Control method according to any of the claims 9 or 10, wherein the read operation further comprises after the step consisting of applying the second read voltage (Vread2):
- applying a third read voltage (Vread3), of said sequence of read voltages, the third read voltage being different from said first read voltage (Vread1) and second read voltage (Vread2) and belonging to a third range of voltages between the third threshold voltage and a fourth threshold voltage, or
- triggering the end of the read operation:
when the second read voltage (Vread2) is, apart from the first read voltage, the highest voltage of said sequence (Vread1, Vread2, Vread3) of voltages and the second read current corresponds to a leakage current level (loffOTS) of the selector (33) when this selector is in an OFF state, or
when the second read voltage (Vread2) is, apart from the first read voltage, the lowest voltage of said sequence (Vread1, Vread2,...) of voltages and the second read current corresponds to a current level (Ilimit) of the selector (33) when the selector is in an ON state.

12. Control method according to claim 11, wherein the read operation further comprises, after applying the third read voltage (Vread3):
- a step of determining said given programming state as a function of the value of a sum between said first read current, said second read current, and a third current passing through said given cell consecutive to the application of said third read voltage (Vread3).

13. Control method according to any of the claims 11 or 12, further comprising, after applying the second read voltage and prior to the application of the third read voltage or the triggering of the end of the read operation, a binary detection step consisting of determining whether the second read current corresponds to a leakage current level (loffOTS) of the selector (33) when this selector is in an OFF state or if the second current corresponds to a current level (Ilimit) when the selector is in an ON state.

14. Control method according to any of the claims 9 to 13, wherein prior to the read operation, the programming of the given state is performed by applying a succession of current pulses to the given cell.
